# EUROPEAN PATENT SPECIFICATION

(11) **EP 0 509 183 B1**
(45) Date of publication and mention of the grant of the patent: **18.10.1995**
(21) Application number: 91830151.6
(22) Date of filing: 17.04.1991
(51) Int. Cl.: H01L 27/082, H01L 21/76

(54) **Monolithic semiconductor device comprising an integrated control circuit and at least one power transistor integrated in the same chip and the associated manufacturing process**
Monolitische Halbleiteranordnung bestehend aus einer integrierten Kontrollschaltung und aus mindestens einem Leistungstransistor, die auf demselben Chip integriert sind und Herstellungsverfahren
Dispositif semi-conducteur monolithique comprenant un circuit de commande intégré et au moins un transistor de puissance intégré sur la même pièce, et procédé de fabrication associé

(43) Date of publication of application: 21.10.1992
(73) Proprietor: CONSORZIO PER LA RICERCA SULLA MICROELETTRONICA NEL MEZZOGIORNO, 95121 Catania (IT)
(72) Inventor: Zambrano, Raffaele, I-95037 San Giovanni La Punta CT (IT)
(74) Representative: Arena, Giovanni

(56) References cited:
- EP-A- 0 339 732
- PATENT ABSTRACTS OF JAPAN vol. 5, no. 141 (E-73)(813) 5 September 1981 ; & JP-A-56 074 940
- PATENT ABSTRACTS OF JAPAN vol. 5, no. 159 (E-77)(831) 14 October 1981 ; & JP-A-56 087 360
- PATENT ABSTRACTS OF JAPAN vol. 6, no. 91 (E-109)(969) 28 May 1982 ; & JP-A-57 026 462
- PATENT ABSTRACTS OF JAPAN vol. 9, no. 189 (E-333)(1912) 6 August 1985 ; & JP-A-60 058 633
- PATENT ABSTRACTS OF JAPAN vol. 10, no. 39 (E-381)(2096) 15 February 1986 ; & JP-A-60 196 936

## Description

The object of the present invention is a monolithic semiconductor device comprising an integrated control circuit and at least one power transistor integrated in the same chip and the associated manufacturing process.

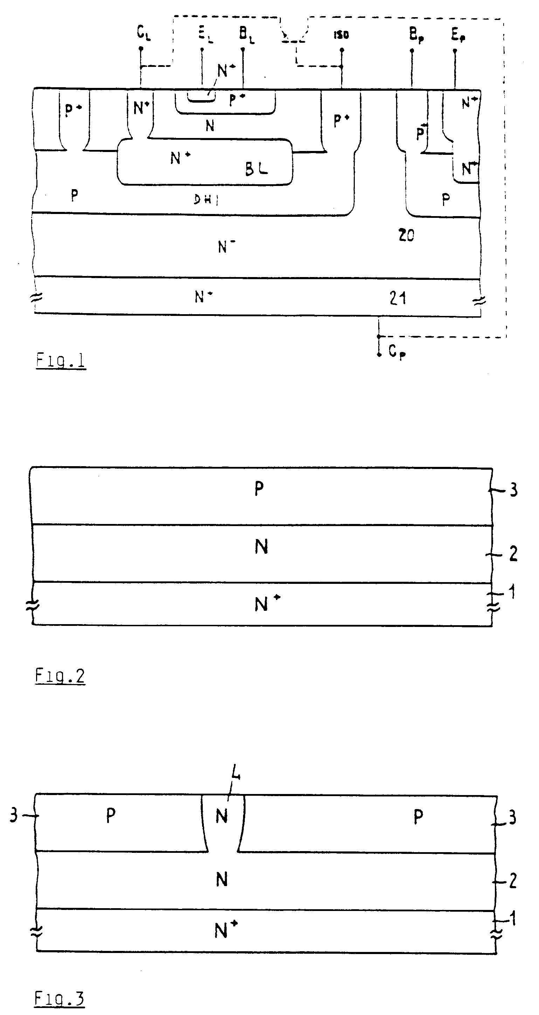

In known monolithic devices of the above-mentioned type the control circuit usually comprises several low voltage transistors and a type p diffused horizontal isolation (DHI) region obtained by selective dopant implantation and subsequent diffusion. Since the DHI region gives rise, together with the collector regions of the power transistor and the type n buried layer (BL of FIG. 1), to a parasite npn transistor whose firing should be avoided, it involves a very deep junction and very critical dopant profile design. Other devices are described in JP-A-5687360 and JP-A-5674940

This reflects negatively on device performance, costs and productivity.

The monolithic semiconductor device in accordance with the present invention as claimed in claims 1 and 2 and process of claim 6 overcomes the above shortcomings and achieves other advantages.

In accordance with an inventive solution it comprises at least one transistor of an integrated control circuit, a horizontal isolation region for said circuit, and at least one bipolar power transistor integrated in the same chip, with power transistor and control circuit transistor both of type npn or pnp and is characterized in that:
- the chip comprises a substrate with a first type of conductivity and three overlying epitaxial layers, the first and third of which having the first type of conductivity and the second having a second type of conductivity opposed to the above;
- the epitaxial layer with the second type of conductivity has uniform or variable dopant concentration with higher doping at the interface with the underlying epitaxial layer and lower doping at the interface with the upper epitaxial layer; - both the horizontal isolation region of the control circuit and the power transistor base consist of portions of the second epitaxial layer. Other innovative solutions are indicated in the claims set forth below.

The invention will be further clarified by the description given below and the annexed drawings of an example of the known art and nonlimiting examples of embodiments of the invention in which:
- FIG.1: shows a monolithic semiconductor device in accordance with the known art comprising an integrated control circuit and a power stage integrated in the same chip,
- FIGS.2-7: show the steps of a manufacturing process for a device in accordance with the present invention,
- FIGS.8a and 8b: show a first variant on the manufacturing process of FIGS. 2-7,
- FIGS.9a and 9b: show a second variant of the manufacturing process of said figures.
- FIG.10: shows an example of a structure with a power stage comprising an npn transistor and an integrated control circuit comprising a pnp transistor,
- FIG.11: shows an example of the structure with power stage comprising an npn transistor and an integrated control circuit comprising both an npn transistor and a pnp transistor.

FIG.1 shows schematically the structure of a monolithic semiconductor device in accordance with the known art comprising an integrated control circuit and a power stage integrated in the same chip.

It shows for the sake of simplicity a single component of the integrated control circuit (the low voltage npn transistor with emitter, base and collector terminals E_{L}, B_{L} and C_{L} ) and a single power transistor (the npn transistor with emitter, base and collector terminals E_{P}, B_{P} and C_{P}).

The horizontal isolation region of the integrated control circuit, indicated by reference DHI (diffused horizontal isolation) and the power transistor base are provided by type p regions obtained by a selective implantation process followed by a diffusion cycle.

The dopant concentration of this DHI region is determined on the basis of two opposing requirements, i.e.:
- the need for low dopant concentrations, to increase the operating voltage of the integrated control circuit components, (e.g. to obtain a 60 V breakdown voltage of the insulation a peak concentration of 10¹⁶ atoms/m³ must not be exceeded),
- the need for high concentrations to reduce gain of the npn parasite transistor shown in broken lines in FIG. 1 and its reverse, obtained by exchanging the emitter with the collector.

Formation of the type n buried layer (BL region) tends to partially compensate for the dopant introduced to form the DHI region, consequently increasing both the resistivity of the DHI region and the gain of the npn parasite transistor mentioned above.

Concerning the power stage, the parameters penalized by the above mentioned compromise solution are the reverse breakdown safe operating area (RBSOA) and the switching characteristics, because of the high intrinsic basic resistance r_{bb′}.

Heavy diffusions are therefore obligatory for the DHI region (with junction depth after diffusion even greater than 10 micron) so as to avoid excessive compensation for this region by the BL region.

Among other things the result is a considerable rise of the substrate 21 (doped with Sb), and therefore an increase in the thickness of the first epitaxial layer 20, which penalizes costs and productivity.

The manufacturing process sequence of the device which is the object of the present invention is shown schematically in FIGS. 2-7 in which, for the sake of simplicity, only one component of the integrated control circuit is considered (a low voltage npn transistor) and a single power transistor, also npn.

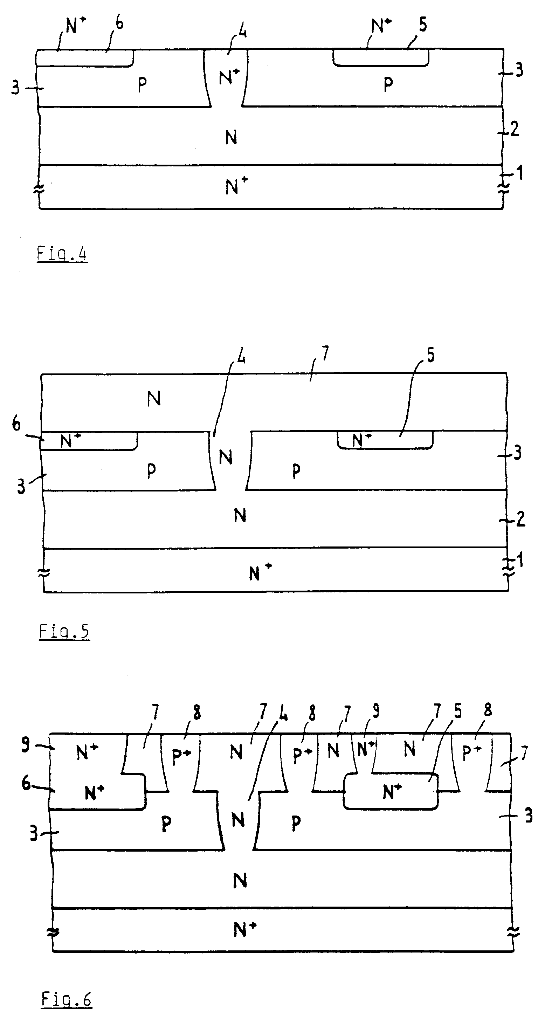

The sequence provides:
1) growth of a type n epitaxial layer 2 on a type n+ substrate 1 (FIG. 2);
2) growth of a type p epitaxial layer 3 on the preceding type n epitaxial layer 2 (FIG. 2); this second growth takes place immediately after the previous one without intervening operations;
3) definition of the diffused region 4 separating the integrated control circuit from the power stage (FIG. 3);
4) definition of the regions 5 for formation of the type n buried layer of the integrated control circuit and 6 for formation of the power transistor emitter (FIG. 4);
5) growth of a type n new epitaxial layer 7 (FIG. 5);
6) provision of the regions 8 to isolate the integrated control circuit components from each other and from the power transistor (FIG. 6);
7) Provision of the sink regions 9 to connect the buried layer 5 and the emitter 6 to the surface (FIG. 6);

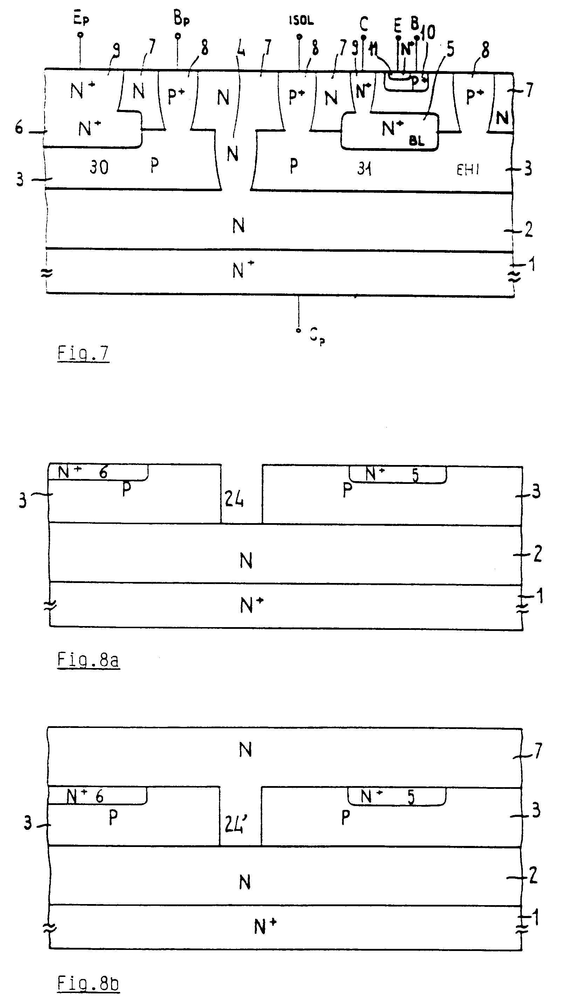

The structure obtained in accordance with the above process is illustrated in FIG. 7 where reference number 30 indicates the base region of the power transistor and 31 the horizontal isolation region of the integrated control circuit.

It differs from known structures in that the DHI regions are replaced by epitaxial horizontal isolation (EHI) regions of the type p epitaxial layer 3 which is grown after the type n epitaxial layer 2 in a single step or in two distinct steps without other intervening operations, as already mentioned.

The concentration of this layer is uniform all over and equal to the peak concentration of the equivalent diffused region. Resistivity of the EHI regions and gain of the parasite transistor are therefore minimized at the same time.

It is also possible to grow an epitaxial layer 3 with variable doping, e.g. more highly doped at the interface with the epitaxial layer 2 than at the interface with the epitaxial layer 7, and this is obtained by varying the flow of dopant in the reactor used for growth during the epitaxial growth step. Said epitaxial layer with variable doping in the sense set forth above further reduces the resistivity of the horizontal isolation region and the gain of the parasite transistor without compromising the maximum operating voltage of the integrated pilot circuit components.

The structure of FIG.7 is advantageous for the power stage also.

Indeed, the bipolar power transistor has an epitaxial base and it is known that this makes it possible to reduce the r_{bb′} and thus obtain switching and robustness characteristics better than those of a transistor with diffused base region and peak concentration equal to that of the epitaxial layer as a result of the reduced extrinsic base resistance. In addition the base region can be further enriched with dopant where necessary by selective implantation.

The characteristics of the power transistor are improved because the emitter region doping has a profile such that it maximizes the efficiency of said region.

Naturally the above described process is capable of variation. Two possible variants call for the omission of step 3).

Indeed, in accordance with a first variant the region 4 which isolates the power stage from the integrated control circuit can be provided, instead of by a diffused region, by digging opposite thereto, before step 5), a groove or trench 24 in the epitaxial layer 3 by selective anisotropic etching of said layer (FIG. 8a). Said trench is then filled by the epitaxial layer 7 during its growth so as to arrive at, at the end of step 5) indicated above, region 24′ of the structure of FIG. 8b.

In accordance with another variant the region 4 and the region 7 overlying said region 4 of FIG. 6 are replaced by a trench 14 in the layers 7 and 3 for their entire depth and part of the layer 2 and provided by selective anisotropic etching as for the above case after step 5 so as to arrive at the structure of FIG.9a.

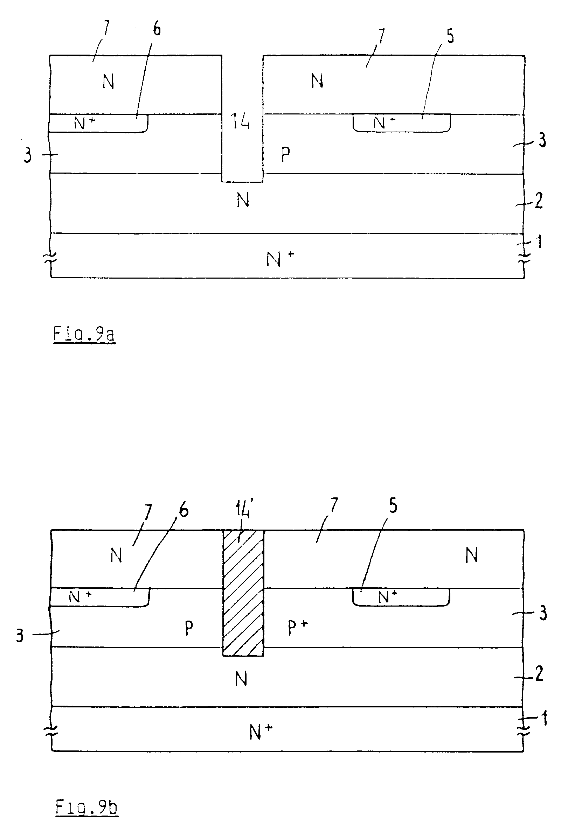

Subsequently, before the beginning of step 6, said trench is filled with dielectric material, e.g. SiO₂, as shown in FIG. 9b.

It is noted that the structure in accordance with all the variants can be used in a manner apparent to those skilled in the art even for the construction of devices with integrated control circuit comprising pnp transistors with vertical current flow, e.g. of the type described in U.S. patent 4,898,836 filed by SGS-THOMSON Microelectronics. In this case the EHI region serves as the collector for the pnp transistors.

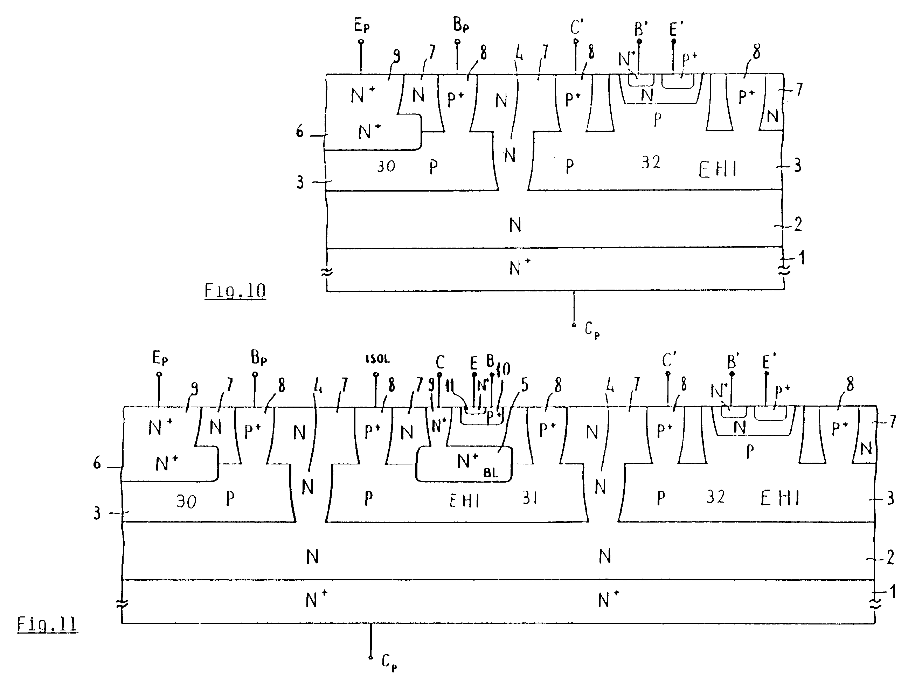

FIG.10 shows an example of a structure with the power stage comprising an npn transistor and an integrated control circuit comprising a pnp transistor whose collector region, indicated by reference number 32, leads to the electrode C′ and whose base and emitter regions lead to the electrodes B′ and E′.

FIG.11 shows an example of a structure with a power stage comprising an npn transistor and an integrated control circuit comprising both an npn transistor and a pnp transistor.

If it is desired to provide a power transistor of pnp type it is sufficient to repeat the structures and processes described with reference to FIGS. 2-11 by reversing the type of conductivity of the various layers and regions, thus beginning the structure from a type p substrate, etc.

The above description makes clear the advantages of the structure obtained by the process which is the object of the present invention as compared with the structures obtained by the process of the known art and which may be summarized as follows:
1) simultaneous minimisation of the resistivity of the horizontal isolation region and the gain of the parasite transistors;
2) optimization of the performance of the power stage as a result of reduction of the extrinsic base resistance;
3) reduction of the thickness of the first epitaxial layer because heavy diffusions for the DHI regions are no longer necessary.

The following two advantages apply essentially to the process represented in FIGS. 9a and 9b:
4) the regions which have to hold high voltages, i.e. those between the layers 2 and 3, are flat, hence it is not necessary to use termination techniques, with a resulting saving of area and processing costs;
5) the doping of the epitaxial layer 7 is independent of the operating voltage of the power stage because there are no regions in which it makes contact with the epitaxial layer 2.

The above description is given for a power stage provided with a single transistor. But the invention is applicable to a power stage with several transistors, e.g. darlington or trilington transistors.

## Claims

1. Monolithic semiconductor device comprising at least one bipolar transistor of an integrated control circuit, one horizontal isolation region of said circuit, and at least one bipolar power transistor integrated in the same chip and with the power transistor and control circuit transistor both of type npn or pnp, characterized in that:
- the chip comprises a substrate (1) of a first type of conductivity and three overlying epitaxial layers (2, 3,7) with the first and third of said epitaxial layers having a first type of conductivity and the second of said layers having a second type of conductivity opposite to the first;
- the epitaxial layer (3) of the second type of conductivity has a uniform or variable dopant concentration with more doping at the interface with the underlying epitaxial layer (2) and less doping at the interface with the upper epitaxial layer (7);
- both the horizontal isolation region (31) of the control circuit and the base region (30) of the power transistor consist of portions of the second epitaxial layer (3).

2. Monolithic semiconductor device comprising at least one bipolar transistor of an integrated control circuit, one horizontal isolation region of said circuit and at least one bipolar power transistor integrated in the same chip and with power transistor and control circuit transistor of type npn and pnp respectively or vice versa, characterized in that:
- the chip comprises a substrate (1) of a first type of conductivity and three overlying epitaxial layers (2, 3,7) with the first, second and third of said epitaxial layers having a first type of conductivity, a second type of conductivity opposite the preceding one, and the first type of conductivity respectively;
- the epitaxial layer (3) of the second type of conductivity has uniform or variable dopant concentration with more doping at the interface with the underlying epitaxial layer (2) and less doping at the interface with the upper epitaxial layer (7);
- both the collector region (32) of the control circuit transistor and the base region (30) of the power transistor consist of portions of the second epitaxial layer (3).

3. Monolithic semiconductor device in accordance with claim 1 or 2 characterized in that the power transistor and the control circuit are separated from each other by two regions (4,7) of the first type of conductivity and of which one (4) is the diffused type.

4. Monolithic semiconductor device in accordance with claim 1 or 2 characterized in that the power transistor and the control circuit are separated from each other by two regions (24′,7) with the first type of conductivity and of which one (24′) consists of a trench (24) filled with a portion of said third epitaxial layer.

5. Monolithic semiconductor device in accordance with claim 1 or 2 characterized in that the power transistor and the control circuit are separated from each other by a trench (14) in the second and third epitaxial layers for their entire depth and part of the first epitaxial layer filled with dielectric material (14′).

6. Process of manufacturing a monolithic semiconductor device comprising an bipolar transistor integrated control circuit, a horizontal isolation region of said circuit and at least one bipolar power transistor integrated in the same chip, characterized by the following steps:
a) growth of a first epitaxial layer (2) with a first type of conductivity on a substrate (1) with the same type of conductivity;
b) growth of a second epitaxial layer (3) with a second type of conductivity opposite to that of the aforesaid first epitaxial layer (2);
c) definition in the second epitaxial layer (3) of a region (5) with the first type of conductivity designed to constitute a buried layer of the integrated control circuit, and of a region (6) also with the first type of conductivity designed to form the emitter of the power transistor;
d) growth of a third epitaxial layer (7) with the first type of conductivity;
e) provision in the said third epitaxial layer (7) of regions (8) with the second type of conductivity designed to isolate the integrated control circuit components from each other and from the power transistor;
f) provision in said third epitaxial layer of sink regions (9) designed to connect at the surface the buried layer of the integrated control circuit and the power transistor emitter;

7. Manufacturing process in accordance with claim 6 characterized in that growth of the second epitaxial layer (3) takes place immediately after growth of the first epitaxial layer (2) without other intervening operations.

8. Process in accordance with claim 7 characterized in that between steps b) and c) takes place a step of definition in the second epitaxial layer (3) of a diffused region (4) with the first type of conductivity and designed to separate the integrated control circuit from the power transistor.

9. Process in accordance with claim 7 characterized in that between step c) and step d) there is created a trench (24) in the second epitaxial layer by selective anisotropic etching, said trench being designed to be filled by the growth of the third epitaxial layer during the following step d) and to constitute a region (24′) of isolation of the power transistor from the control circuit.

10. Manufacturing process in accordance with claim 7 characterized in that between step d) and step e) a trench (14) is created by selective anisotropic etching, in the third and second epitaxial layers for their entire depth and part of the depth of the first epitaxial layer, which is subsequently filled with dielectric material and is designed to constitute an isolation region for the power stage of the control circuit and to level all the junctions subject to high voltage.

11. Device in accordance with claim 1 or 2 characterized in that the emitter region of the power transmitter has a doping profile designed to maximize the efficiency of said emitter.

## Patentansprüche

1. Monolithische Halbleiteranordnung, die, in demselben Chip integriert, mindestens einen bipolaren Transistor einer integrierten Steuerschaltung, eine horizontale Trennzone dieser Schaltung und mindestens einen bipolaren Leistungstransistor enthält, wobei der Leistungstransistor und der Transistor der Steuerschaltung beide vom npn- oder vom pnp-Typ sind, dadurch gekennzeichnet, daß:
- der Chip ein Substrat (1) eines ersten Leitfähigkeitstyps und drei darüberliegende Epitaxieschichten (2, 3, 7) aufweist, deren erste und dritte von einem ersten Leitfähigkeitstyp sind und deren zweite von einem zweiten, dem ersten Leitfähigkeitstyp entgegengesetzten Leitfähigkeitstyp ist;
- die Epitaxieschicht (3) des zweiten Leitfähigkeitstyps eine gleichmäßige oder eine variable Dotierstoffkonzentration mit mehr Dotierstoff an der Grenzfläche zur darunterliegenden Epitaxieschicht (2) und weniger Dotierstoff an der Grenzfläche zur oberen Epitaxieschicht (7) hat;
- sowohl die horizontale Trennzone (31) der Steuerschaltung als auch die Basiszone (30) des Leistungstransistors aus Teilen der zweiten Epitaxieschicht (3) bestehen.

2. Monolithische Halbleiteranordnung, die, in demselben Chip integriert, mindestens einen bipolaren Transistor einer integrierten Steuerschaltung, eine horizontale Trennzone dieser Schaltung und mindestens einen bipolaren Leistungstransistor enthält, wobei der Leistungstransistor vom npn-Typ und der Transistor der Steuerschaltung vom pnp-Typ sind, oder umgekehrt, dadurch gekennzeichnet, daß:
- der Chip ein Substrat (1) eines ersten Leitfähigkeitstyps und drei darüberliegende Epitaxieschichten (2, 3, 7) aufweist, deren erste von einem ersten Leitfähigkeitstyp, deren zweite von einem dem ersten Leitfähigkeitstyp entgegengesetzten zweiten Leitfähigkeitstyp und deren dritte vom ersten Leitfähigkeitstyp ist;
- die Epitaxieschicht (3) des zweiten Leitfähigkeitstyps eine gleichmäßige oder variable Dotierstoffkonzentration mit mehr Dotierstoff an der Grenzfläche zur darunterliegenden Epitaxieschicht (2) und weniger Dotierstoff an der Grenzfläche zur oberen Epitaxieschicht (7) hat;
- sowohl die Kollektorzone (32) des Transistors der Steuerschaltung als auch die Basiszone (30) des Leistungstransistors aus Teilen der zweiten Epitaxieschicht (3) bestehen.

3. Monolithische Halbleiteranordnung nach Anspruch 1 oder 2, dadurch gekennzeichnet, daß der Leistungstransistor und die Steuerschaltung voneinander durch zwei Zonen (4, 7) des ersten Leitfähigkeitstyps getrennt sind, von denen eine (4) der diffundierte Typ ist.

4. Monolithische Halbleiteranordnung nach Anspruch 1 oder 2, dadurch gekennzeichnet, daß der Leistungstransistor und die Steuerschaltung voneinander durch zwei Zonen (24′, 7) des ersten Leitfähigkeitstyps voneinander getrennt sind, deren eine (24′) aus einem Graben (24) besteht, der mit einem Teil der dritten Epitaxieschicht aufgefüllt ist.

5. Monolithische Halbleiteranordnung nach Anspruch 1 oder 2, dadurch gekennzeichnet, daß der Leistungstransistor und die Steuerschaltung voneinander durch einen Graben (14) getrennt sind, der über die ganze Tiefe der zweiten und der dritten Epitaxieschicht und in einen Teil der ersten Epitaxieschicht reicht und mit dielektrischem Material (14′) gefüllt ist.

6. Verfahren zur Herstellung einer monolithischen Halbleiteranordnung, die, in demselben Chip integriert, einen bipolaren Transistor, eine integrierte Steuerschaltung, eine horizontale Trennzone dieser Schaltung und mindestens einen bipolaren Leistungstransistor enthält, gekennzeichnet durch die folgenden Schritte:
a) Züchtung einer ersten Epitaxieschicht (2) eines ersten Leitfähigkeitstyps auf einem Substrat (1) desselben Leitfähigkeitstyps;
b) Züchtung einer zweiten Epitaxieschicht (3) eines zweiten Leitfähigkeitstyps, der demjenigen der genannten ersten Epitaxieschicht (2) entgegengesetzt ist;
c) in der zweiten Epitaxieschicht (3) Definierung einer Zone (5) des ersten Leitfähigkeitstyps, die zur Bildung einer überdeckten Schicht der integrierten Steuerschaltung angelegt ist, und einer ebenfalls den ersten Leitfähigkeitstyp aufweisenden Zone (6), die zur Bildung des Emitters des Leistungstransistors angelegt ist;
d) Züchtung einer dritten Epitaxieschicht (7) des ersten Leitfähigkeitstyps;
e) in der dritten Epitaxieschicht (7) Bildung von Zonen (8) des zweiten Leitfähigkeitstyps, die angelegt sind, um die Komponenten der integrierten Steuerschaltung voneinander und vom Leistungstransistor zu trennen;
f) in der dritten Epitaxieschicht Bildung von Senkenzonen (9), die angelegt sind, um die Oberfläche der überdeckten Schicht der integrierten Steuerschaltung und den Emitter des Leistungstransistors zu verbinden.

7. Herstellungsverfahren nach Anspruch 6, dadurch gekennzeichnet, daß die Züchtung der zweiten Epitaxieschicht (3) unmittelbar nach der Züchtung der ersten Epitaxieschicht (2) ohne andere Zwischenoperationen stattfindet.

8. Verfahren nach Anspruch 7, dadurch gekennzeichnet, daß zwischen den Schritten b) und c) ein Schritt stattfindet, durch den in der zweiten Epitaxieschicht (3) eine Diffusionszone (4) des ersten Leitfähigkeitstyps gebildet wird, die angelegt ist zur Trennung der integrierten Steuerschaltung vom Leistungstransistor.

9. Verfahren nach Anspruch 7, dadurch gekennzeichnet, daß zwischen dem Schritt c) und dem Schritt d) durch selektive anisotrope Ätzung in der zweiten Epitaxieschicht ein Graben (24) geschaffen wird, der angelegt ist, um durch die Züchtung der dritten Epitaxieschicht während des nachfolgenden Schritte d) gefüllt zu werden und eine Zone (24′) zum Trennen des Leistungstransistors von der Steuerschaltung zu bilden.

10. Herstellungsverfahren nach Anspruch 7, dadurch gekennzeichnet, daß zwischen dem Schritt d) und dem Schritt e) durch selektive anisotrope Ätzung ein Graben (14) über die gesamte Tiefe der dritten und der zweiten Epitaxieschicht und einen Teil der Tiefe der ersten Epitaxieschicht geschaffen wird, der anschließend mit dielektrischem Material gefüllt wird und angelegt ist, um eine Trennzone für die Leistungsstufe zu bilden und alle einer hohen Spannung ausgesetzten Halbleiterübergänge zu nivellieren.

11. Anordnung nach Anspruch 1 oder 2, dadurch gekennzeichnet, daß die Emitterzone des Leistungstransistors ein Dotierungsprofil hat, das zur Maximierung des Wirkungsgrades des genannten Emitters ausgelegt ist.

## Revendications

1. Dispositif semiconducteur monolithique comprenant au moins un transistor bipolaire d'un circuit intégré de commande, une région d'isolement horizontal du circuit, et au moins un transistor bipolaire de puissance intégré dans la même puce, le transistor de puissance et le transistor du circuit de commande étant tous deux de type NPN ou PNP, caractérisé en ce que que :
la puce comprend un substrat (1) d'un premier type de conductivité et au moins trois couches épitaxiées de recouvrement (2, 3, 7), les première et troisième couches épitaxiées ayant un premier type de conductivité et la deuxième de ces couches ayant un second type de conductivité opposé au premier ;
la couche épitaxiée (3) du second type de conductivité a une concentration en dopants uniforme ou variable avec plus de dopage à l'interface avec la couche épitaxiée sous-jacente (2) et moins de dopage à l'interface avec la couche épitaxiée supérieure (7) ;
la région d'isolement horizontal (31) du circuit de commande et la région de base (30) du transistor de puissance consistent en des parties de la deuxième couche épitaxiée (3).

2. Dispositif semiconducteur monolithique comprenant au moins un transistor bipolaire d'un circuit intégré de commande, une région d'isolement horizontal du circuit et au moins un transistor bipolaire de puissance intégré dans la puce, le transistor de puissance et le transistor du circuit de commande étant respectivement de type NPN et PNP, ou inversement, caractérisé en ce que :
la puce comprend un substrat (1) d'un premier type de conductivité et trois couches épitaxiées de recouvrement (2, 3, 7), les première, deuxième et troisième couches épitaxiées ayant un premier type de conductivité, un second type de conductivité opposé au précédent, et le premier type de conductivité, respectivement ;
la couche épitaxiée (3) du second type de conductivité a une concentration en dopants uniforme ou variable avec plus de dopants à l'interface avec la couche épitaxiée sous-jacente (2) et moins de dopants à l'interface avec la couche épitaxiée supérieure (7) ;
la région de collecteur (32) du transistor du circuit de commande et la région de base (30) du transistor de puissance consistent en des parties de la deuxième couche épitaxiée (3).

3. Dispositif semiconducteur monolithique selon la revendication 1 ou 2, caractérisé en ce que le transistor de puissance et le circuit de commande sont séparés l'un de l'autre par deux régions (4, 7) du premier type de conductivité dont l'une (4) est de type diffusé.

4. Dispositif semiconducteur monolithique selon la revendication 1 ou 2, caractérisé en ce que le transistor de puissance et le circuit de commande sont séparés l'un de l'autre par deux régions (24′, 7) du premier type de conductivité dont l'une (24′) comprend une tranchée (24) remplie d'une partie de la troisième couche épitaxiée.

5. Dispositif semiconducteur monolithique selon la revendication 1 ou 2, caractérisé en ce que le transistor de puissanoe et le circuit de commande sont séparés l'un de l'autre par une tranchée (14) sur toute la profondeur des seconde et troisième couches épitaxiées et sur une partie de la première couche épitaxiée, remplie de matériau diélectrique (14′).

6. Procédé de fabrication d'un dispositif semiconducteur monolithique comprenant un circuit intégré de commande à transistors bipolaires, une région d'isolement horizontal du circuit et au moins un transistor bipolaire de puissance intégré dans la même puce, caractérisé par les étapes suivantes :
a) croissance d'une première couche épitaxiée (2) d'un premier type de conductivité sur un substrat (1) du même type de conductivité ;
b) croissance d'une deuxième couche épitaxiée (3) d'un second type de conductivité opposé à celui de la première couche épitaxiée (2) ;
c) définition dans la deuxième couche épitaxiée (3) d'une région (5) du premier type de conductivité destinée à constituer une couche enterrée du circuit intégré de commande, et d'une région (6), également du premier type de conductivité, destinée à former l'émetteur du transistor de puissance ;
d) croissanoe d'une troisième couche épitaxiée (7) du premier type de conductivité ;
e) prévision dans ladite troisième couche épitaxiée (7) de régions (8) du second type de conductivité destinées à isoler les composants du circuit intégré de commande les uns des autres et du transistor de puissance ;
f) prévision dans la troisième couche épitaxiée de régions de puits (9) destinées à connecter en surface la couche enterrée du circuit intégré de commande et l'émetteur du transistor de puissance.

7. Procédé de fabrication selon la revendication 6, caractérisé en ce que la croissance de la deuxième couche épitaxiée (3) prend place immédiatement après la croissance de la première couche épitaxiée (2) sans autres opérations intercalaires.

8. Procédé selon la revendication 7, caractérisé en ce que, entre les étapes b) et c), prend place une étape de définition dans la deuxième couche épitaxiée (3) d'une région diffusée (4) du premier type de conductivité et destinée à séparer le circuit intégré de commande du transistor de puissance.

9. Procédé selon la revendication 7, caractérisé en ce que, entre l'étape c) et l'étape d), une tranchée (24) est créée dans la deuxième couche épitaxiée par gravure anisotrope sélective, la tranchée étant prévue pour être remplie par la croissance de la troisième couche épitaxiée pendant l'étape suivante d) et pour constituer une région (24′) d'isolement du transistor de puissance par rapport au circuit de commande.

10. Procédé de fabrication selon la revendication 7, caractérisé en ce que, entre les étapes d) et e), une tranchée (14) est créée par gravure anisotrope sélective, dans les troisième et deuxième couches épitaxiées sur toute leur épaisseur et une partie de l'épaisseur de la première couche épitaxiée, cette tranchée étant ensuite remplie d'un matériau diélectrique destiné à constituer une région d'isolement pour l'étage de puissance du circuit de commande et pour égaliser toutes les jonctions soumises à une haute tension.

11. Dispositif selon la revendication 1 ou 2, caractérisé en ce que la région d'émetteur du transistor de puissance a un profil de dopage destiné à rendre maximum le rendement de l'émetteur.
